Europäisches Patentamt

European Patent Office

Office européen des brevets

(19)

(11) Numéro de publication : **0 282 520 B1**

# (12) FASCICULE DE BREVET EUROPEEN

(45) Date de publication du fascicule du brevet :
08.07.92 Bulletin 92/28

(51) Int. Cl.⁵ : **G11C 16/04**

(21) Numéro de dépôt : **87905766.9**

(22) Date de dépôt : **11.09.87**

(86) Numéro de dépôt international :
**PCT/FR87/00353**

(87) Numéro de publication internationale :
**WO 88/02172 24.03.88 Gazette 88/07**

(54) MEMOIRE NON-VOLATILE A GRILLE FLOTTANTE SANS OXYDE EPAIS.

(30) Priorité : **16.09.86 FR 8612940**

(43) Date de publication de la demande :
**21.09.88 Bulletin 88/38**

(45) Mention de la délivrance du brevet :
**08.07.92 Bulletin 92/28**

(84) Etats contractants désignés :
**DE FR GB IT NL**

(56) Documents cités :
**EP-A- 0 006 510**
**US-A- 4 180 826**
**US-A- 4 258 466**
**US-A- 4 361 847**
**US-A- 4 384 349**
**IEEE Transactions on Electron Devices, vol.**
**ED-26 no.4,April 1979, IEEE (New York, US)**

(56) Documents cités :
**C.P. Ho et al.:"Improved MOS device perfor-**
**mance through the enhanced oxidation of**
**heavily doped n+ silicon", pages 623-630,see**
**figure 11**
**International Electron Devices Meeting 1985,**
**Washington DC, 1-4 December 1985,IEEE**
**(New York, US) K.H. Lee et al.: "Lightlydoped**
**drain structure for advanced CMOS /Twin-tub**
**IV)", pages 242-244,see page 242,column 2,**
**pragraphs 1-3**

(73) Titulaire : **SGS-THOMSON**
**MICROELECTRONICS S.A.**
**7, Avenue Galliéni**
**F-94250 Gentilly (FR)**

(72) Inventeur : **BERGEMONT, Albert**
**26, chemin de Mausec**
**F-38700 La Tronche (FR)**

(74) Mandataire : **Ballot, Paul Denis Jacques et al**
**Cabinet Ballot-Schmit, 7, rue le Sueur**
**F-75116 Paris (FR)**

## Description

La présente invention concerne les mémoires, et plus particulièrement les mémoires non-volatiles électriquement programmables, plus couramment appelées mémoires EPROM; la fabrication des mémoires à grille flottante est plus précisément concernée.

Pour obtenir des mémoires de grande capacité de stockage, par exemple des mémoires capables de stocker jusqu'à 4 Mégabits, on doit réduire le plus possible la dimension de chacune des cellules constituant la mémoire.

Mais on est évidemment limité par des considérations physiques, et notamment par la finesse des motifs que permettent les étapes de photolithographie; on est limité aussi par les paramètres électriques parasites qui sont dus au processus de fabrication et qui perturbent le fonctionnement de la mémoire.

Sauf quelques exceptions qui n'ont pas encore eu de succès industriel, toutes les approches essayées pour conduire à des mémoires de grande capacité correspondent à une technologie dont les points essentiels sont les suivants:

– le point-mémoire individuel est constitué par un transistor ayant une grille flottante réalisée par un premier niveau de silicium polycristallin et une grille de commande réalisée par un deuxième niveau de silicium polycristallin

– les sources des transistors sont connectées à un bus à potentiel bas Vss

– la ligne de mot pour désigner une ligne de cellules est constituée par le deuxième niveau de silicium polycristallin

– la ligne de bit pour lire l'état d'une cellule est constituée par une ligne de métal (aluminium) croisant les lignes de mot et contactant de place en place le drain des transistors

– pour réduire la taille du point-mémoire, on prévoit qu'un seul point de contact est prévu pour deux drains adjacents de deux transistors d'une même colonne, ce contact assurant la connexion à la ligne de bit; de même, on prévoit un seul contact entre les sources de deux transistors adjacents et le bus à Vss

– les transistors sont séparés les uns des autres par de l'oxyde de silicium épais (comparativement à l'oxyde de grille des transistors), et les lignes de bit et lignes de mot passent au dessus de cet oxyde épais

– enfin, l'écriture d'une information dans un cellule de la mémoire se fait de la manière suivante: les sources de tous les transistors de la mémoire sont à un potentiel bas Vss (par exemple zéro volt); la ligne de mot connectée à la grille de commande de la cellule à programmer est portée à un potentiel de programmation Vpp (par exemple 15 volts), tandis que toutes les autres lignes de mot sont au potentiel bas Vss; la ligne de bit correspondant au point à programmer est portée à un potentiel haut Vcc (par exemple 10 volts), tandis que les lignes de bit des points qui ne doivent pas être programmées sont maintenues au potentiel bas Vss.

Avec cette architecture de mémoire et le mode de programmation associé, il est impératif que le drain d'un transistor soit électriquement isolé, par de l'oxyde épais, du drain des transistors adjacents de la même ligne de mot, faute de quoi on ne pourrait programmer un point mémoire particulier sans programmer ou déprogrammer en même temps les autres.

Mais l'oxyde épais qui isole deux points adjacents occupe beaucoup de place, surtout lorsqu'il est réalisé par la technique dite d'oxydation localisée.

On a essayé de remplacer l'oxydation localisée par une isolation par tranchées remplies d'oxyde, pour réduire l'encombrement global de la cellule, mais cette technologie n'est pas industriellement au point.

Pour réduire l'encombrement des cellules et ainsi augmenter la capacité de stockage de la mémoire, la présente invention prend une architecture de mémoire qui permet de se dispenser d'une isolation par oxyde épais entre transistors adjacents et qui permet malgrés tout de conserver des procédés de fabrication de type classique si on le désire.

Une architecture qui comporte toutes les caractéristiques de la préambule de la revendication 1 est connue du document US-A-4 384 349. En outre il est connu de US-A-4 180 826 une mémoire à transistors MOS, qui n'a pas d'oxyde épais pour séparer les transistor d'une colonne les uns des autres, mais qui n'est pas électriquement programmable.

Il est connu du document EP-A-0 006 510 un procédé pour former une région de type p au voisinage d'une région dopée de type n+, le procédé comportant une étape d'oxudation effectuée dans des conditions telles que l'oxide qui se forme soit nettement plus épais là où il recouvre des régions dopées de type n+ que là où il recouvre le substrat de type p-.

L'invention est défini par les caractéristiques de la revendication 1.

L'invention propose aussi un procédé de fabrication particulièrement adapté à cete architecture.

Selon un mode particulier de réalisation de l'invention, la mémoire comprend des moyens de programmation agencés pour appliquer aux différentes cellules les potentiels suivants:

– aux lignes de mot des rangées de cellules qui ne doivent pas être programmées, on applique un potentiel bas Vss;

– à la ligne de mot reliée à la cellule à programmer, on applique un potentiel de programmation Vpp;

– à toutes les lignes de bit situées d'un côté de la colonne contenant la cellule à programmer, on applique un potentiel de drain Vcc, et à toutes les lignes de bit situées de l'autre côté de la colonne contenant la cellule à programmer, on applique un potentiel de source;

le potentiel de source, le potentiel de drain et le potentiel de programmation sont tels que le transistor qui a une électrode principale au potentiel de source, l'autre au potentiel de drain et son électrode au potentiel de programmation subisse une programmation et que tout transistor qui a soit ses deux électrodes principales au même potentiel soit son électrode de commande au potentiel bas ne soit pas programmé (c'est le cas pour les transistors à grille flottante classiques à injection par porteurs chauds ).

Dans un autre mode de réalisation, le point-mémoire est également constitué par un transistor à grille flottante, mais la grille flottante ne s'étend que sur une partie du canal, la grille de commande s'étendant directement au dessus du reste du canal.

Le procédé de fabrication selon l'invention est compatible avec les procédés classiques de fabrication de circuits intégrés à transistors MOS, y compris les circuits intégrés à transistors MOS complémentaires (CMOS). En particulier, la mémoire pourra être fabriquée avec des circuits périphériques ( décodeurs notamment) réalisés par une technologie classique avec des zones d'oxyde épais réalisées par oxydation localisée, alors que le plan mémoire proprement dit ne comportera pas d'oxyde épais.

Selon une particularité très importante de l'invention, le procédé de fabrication permet, d'une manière inattendue, de former des régions semiconductrices de type p+ entre des lignes de bit qui sont des régions de type n+, sans étape de masquage spécifique pour délimiter ces régions de type p+ (le substrat étant de type p-).

Pour cela, on forme d'abord des lignes diffusées de type n+, en colonne, des grilles flottantes en silicium polycristallin à chaque position de point mémoire, et des lignes de mot en silicium polycristallin en rangées, puis on réalise une oxydation de la surface de la tranche de circuit intégré, d'une manière telle que, là où le substrat semiconducteur n'est pas recouvert par le silicium polycristallin, de l'oxyde se forme avec une épaisseur plus grande dans les régions dopées de type n+ et moins grande dans les régions où le substrat possède son dopage original p-. Puis, on effectue une implantation de type p avec une dose et une intensité telle que les impuretés traversent l'oxyde là où il est moins épais et soient arrêtées là où il est plus épais et là où du silicium polycristallin est présent.

D'autres caractéristiques et avantages de l'invention apparaitront à la lecture de la description détaillée qui suit et qui est faite en référence aux dessins annexés dans lesquels:

–la figure 1 rappelle l'architecture d'une mémoire EPROM classique;

–la figure 2 représente schématiquement l'architecture d'une autre mémoire EPROM classique;

–la figure 3 représente schématiquement, en vue de dessus, l'implantation relative de quatre points mémoire adjacents sur une tranche de silicium selon l'invention;

–la figure 4 représente une coupe de la figure 3 selon une ligne AA′ parallèle à une ligne de mots de la mémoire;

–la figure 5 représente une coupe de la figure 3 selon une ligne BB′ parallèle à une ligne de bit de la mémoire, c'est-à-dire parallèle à une colonne de la mémoire;

–la figure 6 représente, selon une coupe longitudinale analogue à celle de la figure 4, une variante de réalisation de l'invention.

–les figures 7 à 13 représentent les différentes étapes du procédé de fabrication selon l'invention.

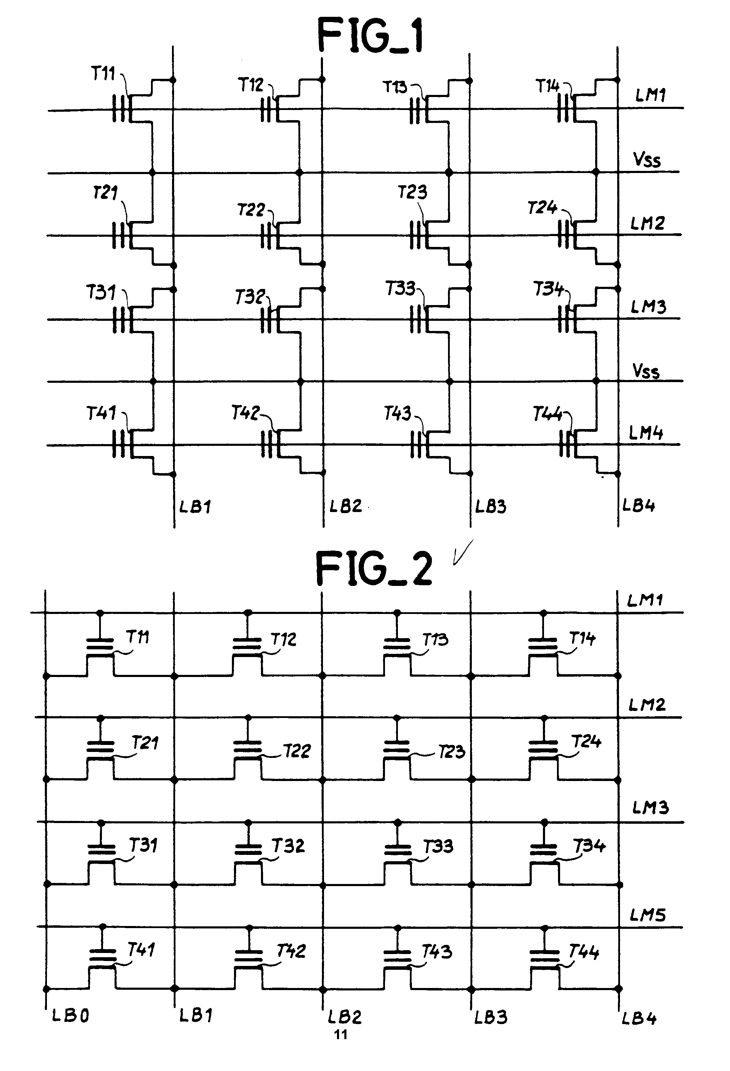

Sur la figure 1 qui représente une mémoire EPROM d'architecture classique, on a désigné par Tij les différents transistors à grille flottante constituant le réseau de points mémoire, où i est un indice de rangée et j un indice de colonne.

Ainsi, les transistors T11 à T14 sont ceux de la première rangée, les transistors T21 à T24 sont ceux de la deuxième rangée, etc.

De même, les transistors T11 à T41 sont ceux de la première colonne, les transistors T12 à T42 sont ceux de la deuxième colonne, etc.

Les transistors possèdent chacun une grille flottante et une grille de commande, ainsi que deux régions semiconductrices d'un premier type de conductivité (source et drain) séparées par une région de canal d'un type de conductivité opposé recouverte par la grille de commande.

Les grilles de commandes des transistors d'une même rangée sont toutes reliées à une même ligne de mot, LM1 à LM4 pour les rangées 1 à 4 respectivement.

Les drains des transistors d'une même colonne sont tous reliés à une même ligne de bit, LB1 à LB4 pour les colonnes 1 à 4 respectivement.

Les lignes de mot sont des conducteurs (en pratique en silicium polycristallin ) s'étendant selon une direction horizontale (direction des rangées). Les lignes de bit sont des conducteurs s'étendant dans une direction verticale ( direction des colonnes).

Les sources de tous les transistors sont reliées à un potentiel bas commun Vss.

Par opposition à cette architecture classique, la figure 2 présente une architecture différente qui est connue de US-A- 4 384 349.

Dans l'architecture de la figure 2, les transistors sont toujours disposés en réseau de rangées et colonnes, les transistors de la première rangée étant encore désignés par T11 à T14, ceux de la deuxième rangée par T21 à T24, et le transistor Tij désignant plus généralement le transistor qui est au carrefour de la rangée i et de la colonne j.

Les grilles de commande des transistors de la rangée i sont encore toutes reliées à un conducteur de direction générale horizontale appelé ligne de mot LMi.

Des conducteurs de direction générale verticale constituent des lignes de bit LB1; mais contrairement au cas de la figure 1, chaque ligne de bit est reliée d'une part à tous les transistors de la colonne située immédiatement à droite de cette ligne de bit, et d'autre part à tous les transistors de la colonne située immédiatement à gauche de cette ligne de bit (sauf naturellement pour les lignes de bit des extrémités, l'une n'ayant pas de transistors à sa gauche et l'autre n'ayant pas de transistors à sa droite ).

Ainsi, en prenant à titre d'exemple la deuxième colonne de transistors T12 à T42, et la troisième colonne de transistors T13 à T43, on voit sur la figure 2 que tous les transistors de la deuxième colonne ont leur drain relié à un conducteur de colonne LB2, et que tous les transistors de la troisième colonne ont leur source reliée à ce même conducteur de colonne LB2.

L'appellation source ou drain n'a pas beaucoup d'importance dans cette architecture et il suffit de retenir que si un transistor a une de ses régions de source ou drain reliée à une ligne de bit, il a alors son autre région (drain ou source) reliée à une ligne de bit immédiatement adjacente à la première.

Avant de décrire la manière de réaliser pratiquement cette architecture, on va maintenant indiquer comment fonctionne cette mémoire en lecture et écriture.

En écriture, on programme un point-mémoire en chargeant sa grille flottante par injection de porteurs chauds, c'est-à-dire en appliquant à la grille de commande, pendant que le transistor conduit un courant entre ses régions de source et de drain, un potentiel suffisamment élevé pour que les porteurs de charge (électrons) soient attirés et piégés dans ,la grille flottante. Ce mode d'injection est classique, mais il nécessite ici des précautions puisque les transistors ne sont pas connectés entre une ligne de bit et une masse à Vss, mais sont connectés entre deux lignes de bit. La notion de ligne de bit correspond à un conducteur susceptible de véhiculer l'information contenue dans un point-mémoire; en ce sens, une ligne de masse à Vss n'est pas une ligne de bit. .

Pour faire fonctionner la mémoire en écriture on opère donc de la manière suivante:

　　–on suppose que le point à programmer est le transistor Tij au croisement de la rangée i et de la colonne j;

　　–la ligne de bit LB1 située immédiatement à droite de la colonne j, et toutes les autres lignes de bit situées à droite de la colonne j sont portées à un potentiel haut Vcc (en pratique de 5 volts), qu'on peut appeler aussi potentiel de drain.

　　–la ligne de bit située immédiatement à gauche de la colonne j et toutes les autres lignes de bit situées à gauche de la colonne j sont portées à un potentiel bas Vss qu'on peut appeler aussi potentiel de source.

Dans ces conditions, seuls les transistors de la colonne j ont un potentiel de drain différent de leur potentiel de source: en effet, les transistors des colonnes plus à droite ont un potentiel Vcc sur leur drain et sur leur source; et les transistors des colonnes plus à gauche ont un potentiel Vss sur leur drain et sur leur source. Les transistors de la colonne j ont du côté gauche (côté que l'on appellera source) un potentiel Vss, et du côté droit (que l'on appellera drain) un potentiel Vcc. Bien entendu la notion de gauche et de droite n'est utilisée ici que par commodité et l'on peut inverser les sens d'application des potentiels.

Par conséquent, seuls les transistors de la colonne j peuvent éventuellement conduire un courant et pourront donc subir une injection de porteurs chauds dans leur grille flottante; les autres ne le pourront pas.

L'injection ne se réalisera cependant que pour les transistors qui auront leur grille portée à un potentiel suffisamment haut dit "potentiel de programmation Vpp".

Deux cas sont possibles:

　　–ou bien l'information à écrire dans le transistor Tij est un "zéro" logique et aucune charge ne doit alors être injectée dans sa grille flottante; dans ce cas, on porte toutes les lignes de mot à un potentiel suffisamment bas (par exemple Vss) pour empêcher toute injection;

　　–ou bien l'information à écrire dans le transistor Tij est un "un" logique et une charge doit être stockée dans sa grille flottante; dans ce cas on porte la ligne de mot LMi (reliée aux transistors de la rangée i) au potentiel de programmation Vpp qui est en pratique de l'ordre de 15 volts.

Toutes les autres lignes de mot sont portées à un potentiel bas (par exemple Vss=0 volt).

Bien entendu, la notion de "zéro" ou "un" logique est arbitraire et on peut aussi bien prévoir que c'est le zéro logique qui correspond à une injection de charges dans la grille flottante.

La lecture de l'information contenue dans un point-mémoire est tout-à- fait similaire à l'écriture.

On applique un potentiel de lecture à la ligne de mot LMi contenant le point à lire, et un potentiel bas à toutes les autres. Le potentiel de lecture appliqué à la ligne LMi est suffisamment haut pour rendre conducteur un transistor dont la grille flottante n'a pas reçu une injection de charges, et suffisamment bas pour ne pas rendre conducteur un transistor dont la grille flottante a subi une injection de charges. Le potentiel bas appliqué aux autres lignes ne permet pas de rendre un transistor conducteur, qu'il ait subi une injection de charges ou non.

Le potentiel bas est par exemple Vss, le potentiel de lecture est par exemple Vcc (environ 5 volts). Comme dans l'opération d'écriture, on applique un potentiel bas à toutes les lignes de bit situées à gauche de la colonne j (par exemple Vss), et un potentiel haut (en principe Vcc à travers une charge résistive), à toutes les lignes de bit situées à droite de la colonne j. Ainsi, seuls les transistors de la colonne j peuvent éventuellement conduire un courant (si toutefois ils sont rendus conducteurs par leur grille de commande); les autres ont le même potentiel sur leur drain et sur leur source et ils ne sont donc parcourus par aucun courant même si le potentiel de leur grille est suffisant pour les rendre conducteurs.

Les transistors de la colonne j ont leur source à Vss et leur drain à Vcc; parmi ces transistors, ceux qui ne font pas partie de la rangée i ont leur grille à un potentiel bas qui empêchent leur mise en conduction; quant au transistor Tij de la rangée i, il a sa grille de commande portée au potentiel de lecture (Vcc en principe); s'il n'a pas subi de stockage de charges dans sa grille flottante, il sera rendu conducteur et conduira effectivement un courant entre son drain et sa source; s'il a subi un stockage de charges, le potentiel de lecture ne sera pas suffisant pour le rendre conducteur et il ne conduira aucun courant entre sa grille et son drain.

Le lecture consiste donc en une détection du courant circulant entre les deux lignes de bit reliées à une colonne de transistors sélectionnée.

Comme pour l'écriture, le principe de lecture de cette mémoire est donc différent de celui d'une mémoire classique en ce sens qu'il nécessite l'application d'un potentiel Vss à toutes les colonnes de gauche et d'un potentiel Vcc à toutes les colonnes de droite, au lieu que ce soit un potentiel Vcc à une colonne sélectionnée et Vss à toutes les autres. On va maintenant décrire la réalisation pratique de cette mémoire selon l'invention et montrer en particulier comment l'architecture permet d'éviter de prévoir, à l'intérieur du réseau de points mémoire, une isolation par oxyde épais entre les drains de transistors de colonnes adjacentes. Cette isolation était absolument nécessaire dans l'architecture classique de la figure 1.

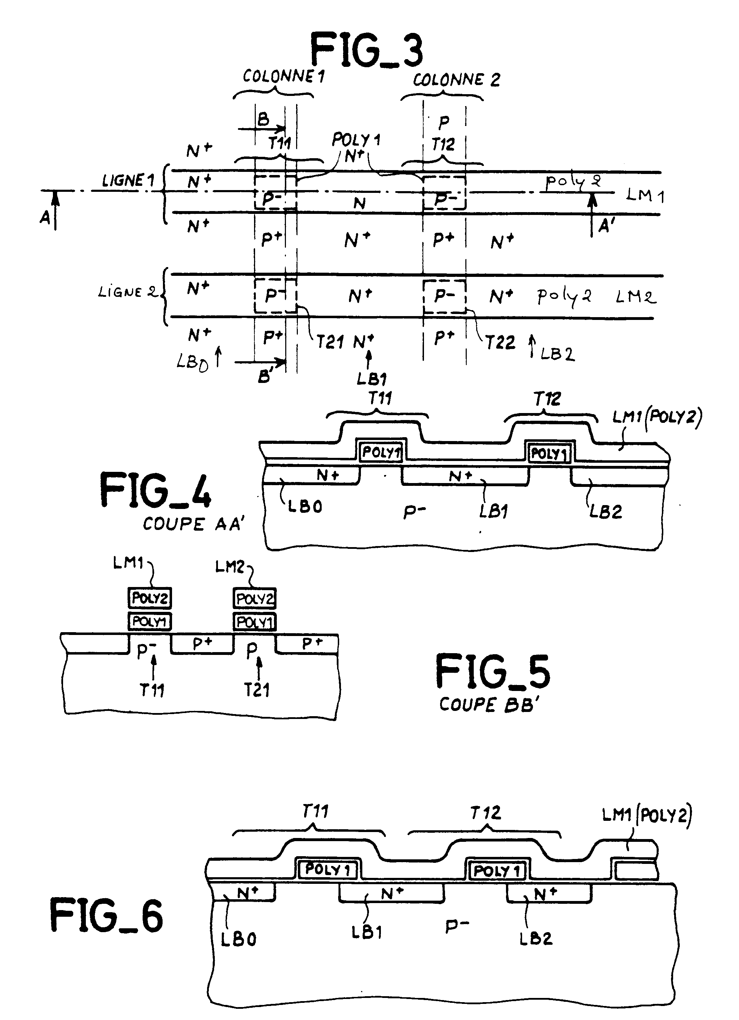

Les figures 3, 4, et 5 doivent être examinées simultanément. Elles représentent une vue schématique de quatres cellules adjacentes de la mémoire, cellule qui correspondent par exemple aux quatre transistors T11, T12, T21, T22 de la figure 2.

Les transistors sont par exemple des transistors à canal n, formés dans un substrat de silicium épitaxié de type p-.

Chaque transistor possède une région de source de type n+ et une région de drain de type n+, ces deux régions étant séparées par une région de canal de type p- recouverte par une grille flottante. La grille flottante est isolée du canal par une couche isolante mince (oxyde de silicium); cette grille flottante est elle-même recouverte d'une grille de commande et isolée d'elle par une autre couche isolante mince.

Les grilles flottantes sont des rectangles de silicium polycristallin obtenus par gravure d'une première couche de silicium polycristallin appelée "premier niveau de silicium polycristallin" (poly 1). Les grilles de commande sont des bandes étroites de silicium polycristallin obtenues par gravure d'une deuxième couche de silicium polycristallin appelée " deuxième niveau de silicium polycristallin" (poly 2). Ces bandes s'étendent dans la direction des rangées horizontales du réseau et elles constituent à la fois les grilles de 'commande et les lignes de mot qui relient ces grilles.

Les lignes de bit sont des bandes fortement dopées de type n+, diffusées dans la surface du substrat de silicium de part et d'autre des colonnes de transistors. Ces lignes diffusées constituent à la fois les lignes de bit et les régions de source et de drain des transistors qui doivent être reliés à ces lignes de bit selon l'architecture de la figure 2.

A l'emplacement d'un transistor, la ligne de bit à droite de ce transistor est isolée de la ligne de bit à gauche de ce transistor; cette isolation résulte tout simplement de la présence du canal du transistor. Mais en dehors des emplacements des transistors, c'est-à-dire entre les rangées de transistors, il faut prévoir une isolation spécifique entre les lignes de bit (régions n+) adjacentes. Dans la structure proposée ici, l'isolation est réalisée 'grâce à des régions de type p, plus fortement dopées que les régions de canal des transistors, ces régions s'étendant dans l'espace compris entre deux lignes de bit adjacentes, entre les canaux de deux transistors de rangées adjacentes.

Si on récapitule la structure de la figure 3, avec les coupes explicatives des figures 4 et 5, on voit que chaque transistor comprend un canal de type p- surmonté par la grille flottante, le canal étant bordé à droite et à gauche par des bandes de type n+ s'étendant sur toute la hauteur (dans la direction des colonnes) du plan-mémoire, ces bandes servant à la fois de sources et drains pour deux colonnes de transistors adjacentes et de lignes de bit pour la transmission d'information vers ou en provenance de la mémoire; par ailleurs, le canal est bordé en haut et en bas par des régions de type p ou p+ qui séparent deux transistors adjacents d'une même colonne. Enfin, en pratique les bandes de silicium polycristallin du niveau 2 formant les lignes de mot et grilles de commande s'étendent horizontalement à la fois au dessus des canaux des transistors et au dessus de portions de régions n+ formant lignes de bit.

D'une manière classique et qui n'a pas besoin d'être détaillée ici, on peut prévoir d'améliorer la conductivité des lignes de bit diffusées en superposant à ces lignes des conducteurs métalliques isolés des lignes de mot et venant contacter de place en place les lignes de bit. Quant aux lignes de mot, on peut améliorer leur conductivité en recouvrant le silicium polycristallin dont elles sont faites par un siliciure métallique.

Une variante de réalisation est représentée à la figure 6. Cette figure représente l'équivalent de la figure 4, c'est à dire une coupe longitudinale à travers les canaux de deux transistors adjacents d'une même rangée.

La différence par rapport à la figure 4 est le fait que les grilles flottantes sont décalées par rapport aux canaux des transistors, c'est-à-dire aux régions de type p- s'étendant entre les lignes 'de bit de type n+.

Comme on le voit sur la' figure 6, les grilles flottantes s'étendent au dessus d'une partie seulement du canal, l'autre partie étant recouverte directement par la grille de commande (avec un isolant mince entre la grille de commande et le canal). La partie de canal qui est recouverte par la grille de commande est celle qui est du côté de la source, c'est-à-dire celle qui est portée à Vss pour des transistors à canal n.

Cette disposition est destinée à empêcher que le couplage capacitif entre la grille flottante et le drain des transistors n'induise une perturbation du fonctionnement de la mémoire lors de l'écriture.

En effet, dans le cas de la figure 4, il se passe le phénomène suivant: pendant l'écriture, toute une colonne de transistors a son drain porté à Vcc; le couplage capacitif entre drain et grille flottante tend à élever le potentiel de la grille flottante à une valeur qui est faible mais suffisante pour commencer à rendre très légèrement conducteur le canal du transistor. Comme ce phénomène se produit simultanément pour tous les conducteurs de la colonne, la conduction totale n'est pas négligeable et le courant qui circule à travers tous ces transistors mis en parallèle tend à faire chuter le potentiel de drain de ces transistors; en particulier, le potentiel de drain du transistor à programmer devient sensiblement inférieur à Vcc, ce qui détériore la qualité de la programmation.

La solution de la figure 6 évite cet inconvénient, non pas en réduisant le couplage capacitif entre source et drain (il est au contraire augmenté), mais en divisant le canal des transistors en deux parties, une partie recouverte par la grille flottante et une partie recouverte uniquement par la grille de commande. De cette manière, même si le couplage capacitif entre drain et grille flottante fait monter le potentiel de la grille flottante, cette augmentation ne peut en tous cas pas rendre conductrice la partie de canal qui n'est pas recouverte par la grille flottante. Or, l'ensemble des transistors de la colonne, sauf un seul, a sa grille de commande portée à un potentiel Vss qui empêche toute conduction de la partie de canal non recouverte par la grille flottante. L'inconvénient du schéma de la figure 4 n'existe donc plus,

On va maintenant décrire un procédé de réalisation particulièrement intéressant pour la présente invention. Le procédé choisi permet de réaliser facilement à la fois le plan mémoire dans lequel les transistors à grille flottante ne sont pas séparés par des zones d'oxyde épais et des circuits périphériques dans lesquels les transistors sont séparés classiquement par des zones d'oxyde épais. Le procédé décrit ci-après correspond à une réalisation des circuits périphériques en technologie CMOS.

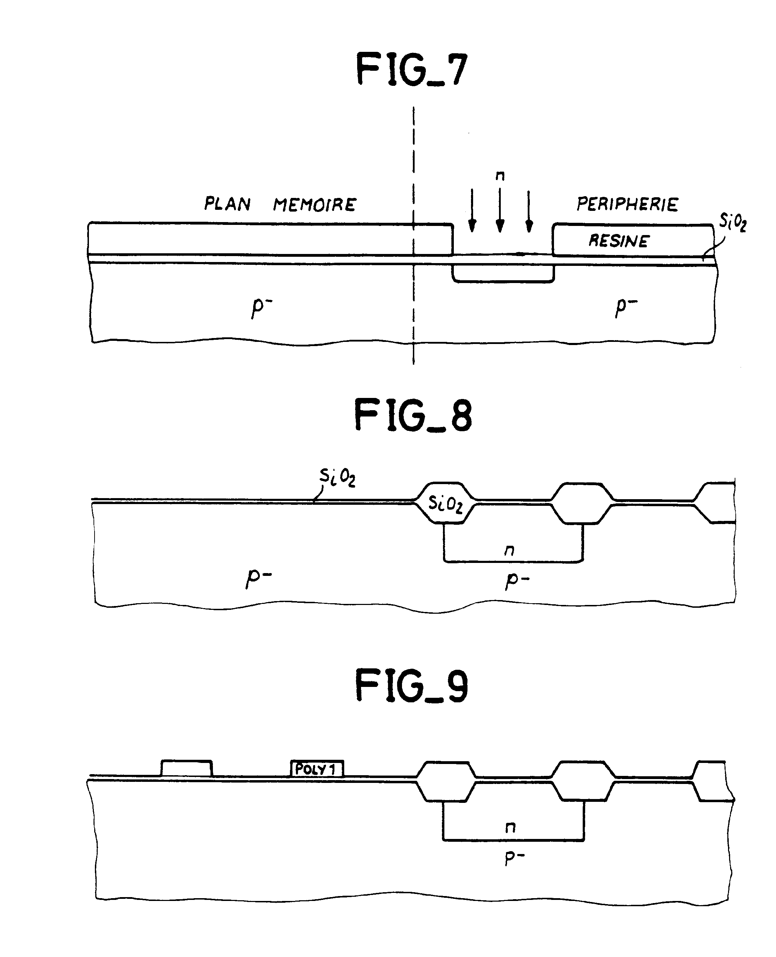

On part d'un substrat de silicium épitaxié de type p-, et on forme une couche mince d'oxyde de silicium à la surface; on recouvre cette couche d'un film de résine photosensible que l'on grave pour définir les caissons de type n- dans lesquels on formera les transistors à canal p des circuits périphériques. On implante une impureté de type n là où la résine ne protège pas le substrat, et on enlève la résine. La figure 7 représente la structure avant enlèvement de la résine.

On effectue ensuite un recuit pour faire diffuser l'impureté jusqu'à une profondeur d'environ 3 à 4 microns, définissant ainsi les caissons de type n.

On enlève l'oxyde présent à la' surface du substrat et on refait croître une couche mince d'oxyde de silicium d'environ 100 à 200 angströms, puis on dépose une couche de nitrure de silicium destinée à la définition des zones d'oxyde épais dans les circuits périphériques.

On photograve le nitrure selon le motif correspondant aux zones d'oxyde épais désirées, et on fait croître l'oxyde épais (environ 0,5 à 0,6 microns) là où le substrat n'est pas protégé par du nitrure.

On élimine le nitrure et l'oxyde mince qui lui a servi de piédestal et on refait croître uniformément une nouvelle couche d'oxyde mince de silicium. La figure 8 représente la structure à ce stade de la fabrication.

On dépose alors une couche uniforme de silicium polycristallin (premier niveau: poly 1). Cette couche de silicium polycristallin a une épaisseur d'environ 2000 angströms et est dopée de type n.

On grave le premier niveau de silicium polycristallin selon un motif de bandes verticales dans le plan mémoire, ces bandes verticales définissant les intervalles qui sépareront les lignes de bit.

La figure 9 représente le substrat à ce stade de la fabrication.

On protège alors par de la résine la périphérie qui ne doit pas subir d'implantation de type n à ce stade. On effectue une implantation d'arsenic là où le substrat de silicium n'est protégé ni par de la résine ni par le premier niveau de silicium polycristallin. Cette implantation définit les lignes de bit de type n +, LBo, LB1, etc.

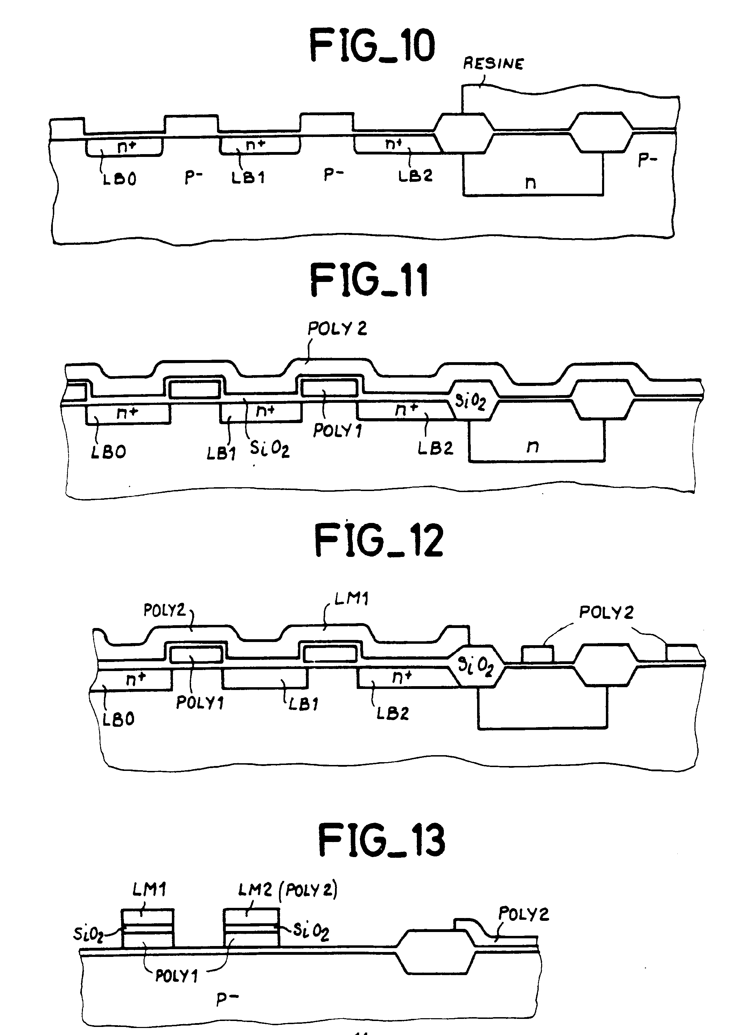

La figure 10 représente la structure à ce stade de fabrication.

On enlève la résine

Il faut noter que l'implantation d'arsenic après dépôt et gravure du premier niveau de silicium polycristallin permet de réaliser la variante de la figure 4 mais pas celle de la figure 6. Pour cette dernière, il faut faire l'implantation d'arsenic à travers un masque de résine puis enlever la résine et déposer et graver le silicium polycristallin selon un motif qui n'est pas autoaligné avec le motif de bandes dopées à l'arsenic.

On fait croître alors un oxyde mince de silicium à la fois sur le substrat et sur le premier niveau de silicium polycristallin. On recouvre de résine le plan mémoire et on enlève l'oxyde mince en dehors du plan mémoire, on enlève la résine et on fait croître à nouveau une couche mince d'oxyde de sillicium qui servira d'isolant de grille aux transistors de la périphérie. Cette couche a une épaisseur d'environ 300 angströms.

On dépose alors une deuxième couche de silicium polycristallin (deuxième niveau: poly 2), et éventuellement on forme à ce stade un siliciure métallique sur cette couche, afin d'augmenter la conductivité de la couche.

La figure 11 représente la structure à ce stade

Par dépôt, insolation et développement d'un masque de résine, on protège le silicium polycristallin dans les zones où on veut qu'il subsiste, et on l'élimine là où il n'est pas protégé. Le motif qui subsiste correspond d'une part aux lignes de mot dans le plan mémoire et d'autre part les grilles de transistors et autres connections souhaitées en dehors du plan mémoire.

On se trouve en présence d'une structure avec des lignes verticales de silicium polycristallin du premier niveau et des lignes horizontales du deuxième niveau. Il faut donc procéder à une nouvelle gravure du premier niveau pour ne conserver que des rectangles définissant les grilles flottantes des transistors du plan mémoire. Il faut donc éliminer le premier niveau de silicium polycristallin entre les bandes horizontales du deuxième niveau et ne le laisser subsister qu'au dessous de ces bandes.

Pour cela, on laisse en place la résine qui a servi à la définition de ces bandes (au lieu de l'enlever comme on le fait généralement après une gravure du silicium polycristallin), et on la durcit par irradiation aux ultraviolets; de cette manière on peut, sans faire disparaître le motif de résine, déposer et étaler une nouvelle couche de résine, puis faire une insolation et un développement de cette résine selon un motif qui protège toute la périphérie et dénude le plan mémoire.

On a alors une structure dans laquelle les lignes de mot du plan mémoire sont protégées par la première couche de résine, et l'ensemble des circuits périphériques sont protégés par la deuxième couche de résine.

On continue alors la gravure du siliciuin polycristallin non protégé par l'une ou l'autre des couches de résine, et il en résulte une disparition du premier niveau de silicium polycristallin entre les bandes horizontales du deuxième niveau.

On enlève les deux couches de résine

Les figures 12 et 13 représentent la structure à ce stade de la fabrication, la figure 12 correspondant à une coupe horizontale analogue à la figure 4, et la figure 13 correspondant à une coupe verticale analogue à la figure 5.

A ce stade, il faut implanter une impureté de type p entre les transistors de rangées adjacentes, mais uniquement dans l'intervalle entre les lignes de bit diffusées; on pourrait utiliser un masque de résine spécifique pour définir les zones d'implantation, mais on préfère utiliser le procédé décrit ci-après.

On effectue une oxydation du substrat à température relativement basse (800 à 900 degrés C) et en atmosphère humide.

L'oxyde croît beaucoup plus vite sur les régions de type n+ du substrat que sur les régions de type p-; on poursuit l'oxydation jusqu'à avoir environ 2000 angströms d'oxyde sur les régions n+ et seulement 500 à 600 angströms sur les régions de type p-. Or ce sont justement les régions de type p- non recouvertes par les lignes de mot qui doivent subir une implantation de type p, tandis que les régions n+ qui sont des lignes de bit ne doivent pas subir cette implantation.

On utilise donc l'oxyde d'épaisseur variable comme masque d'implantation de l'impureté de type p; on dépose cependant une résine de protection que l'on grave pour la laisser subsister seulement dans les zones périphériques et empêcher ainsi l'implantation dans ces zones.

On implante par exemple du bore, avec une énergie suffisante pour traverser l'oxyde recouvrant les régions de type p- et insuffisante pour traverser l'oxyde recouvrant les régions de type n+ et pour traverser le silicium polycristallin là où il est présent.

On aboutit ainsi à la configuration des figures 4 et 5 (ou 6 et 5).

La suite du procédé correspond à la fabrication normale de transistors CMOS dans les zones de la périphérie: avec un masque de résine on protège le plan mémoire et les transistors à canal n, et on implante les régions de source et drain des transistors à canal p; avec un autre masque de résine on protège le plan mémoire et les transistors à canal p et on implante les régions de source et drain des transistors à canal n; on dépose un verre fluant à bas se température (900 à 950° C), par exemple un verre contenant 4% de bore et 5% de phosphore, de manière que le fluage ne conduise pas à une trop grande diffusion latérale des régions de type n+ du substrat.

On grave dans ce verre des trous de contact en vue de la connexion de certaines régions de silicium mono ou polycristallin avec une couche d'interronnexion métallique. On dépose une couche de métal (aluminium), et enfin on la grave.

En particulier, on peut prévoir des lignes métalliques superposées aux lignes de bit (mais isolées d'elles par le verre), ces lignes métalliques venant contacter de place en place les lignes de bit de type n+; par exemple un contact peut être prévu tous les 8 ou 16 rangées de transistors. Les contacts ne doivent pas être prévus trop nombreux car ils nécessitent un accroissement de l'espace entre deux lignes de mot consécutives.

Bien que la description détaillée donnée ici corresponde à des mémoires à grille flottante, l'architecture nouvelle proposée est applicable à d'autres types de mémoires, y compris à des mémoires mortes.

## Revendications

1. Mémoire, comprenant un réseau de lignes de mot (LMI, LM2, ...) reliant des cellules en rangées et de lignes de bit (LB1, LB2, ... ) reliant des cellules en colonne, les lignes de mot étant des conducteurs servant à désigner une rangée de cellules déterminée et les lignes de bit étant des conducteurs permettant de transmettre une information sur l'état logique des cellules qui leur sont connectées, chaque cellule, située au croisement d'une rangée déterminée et d'une colonne déterminée, comprenant un transistor (T11, T12, ... ) ayant une électrode de commande reliée à une ligne de mot, et deux électrodes principales reliées l'une à une première ligne de bit et l'autre à une autre ligne de bit adjacente à la première, cette autre ligne de bit étant elle -même reliée à une électrode principale d'un transistor d'une colonne adjacente à la colonne déterminée dont fait partie la cellule, chaque cellule est constituée par un transistor à grille flottante, les transistors d'un groupe appartenant à deux rangées et deux colonnes adjacentes étant agencés de la manière suivante:
   – chaque transistor comporte une grille flottante essentiellement constituée par un rectangle conducteur situé au dessus d'une zone d'un premier type de conductivité constituant le canal du transistor;
   – les canaux de deux transistors adjacents d'une même colonne sont séparés par une région de même type de conductivité que les canaux;
   – les canaux de deux transistors adjacents d'une même rangée sont adjacents à une même région de type de conductivité opposé qui les sépare et qui sert de source à l'un des transistors et de drain à l'autre.
   caractérisée en ce que
   – il n'y a pas d'oxyde épais formé par oxidation du silicium pour séparer les transistors d'une même colonne les uns des autres.

2. Mémoire selon la revendication 1, caractérisée par le fait qu'elle comprend des moyens de programmation agencés pour appliquer aux différentes cellules les potentiels suivants:
   – aux lignes de mot des rangées de cellules qui ne doivent pas être programmées, on applique un potentiel bas Vss;
   – à la ligne de mot reliée à la cellule à programmer, on applique un potentiel de programmation Vpp;
   – à toutes les lignes de bit situées d'un côté de la colonne contenant la cellule à programmer, on applique un potentiel de drain Vcc, et à toutes les lignes de bit situées de l'autre côté de la colonne contenant la cellule à programmer, on applique un potentiel de source;
le potentiel de source, le potentiel de drain et le potentiel de programmation sont tels que le transistor qui a une électrode principale au potentiel de source, l'autre au potentiel de drain et son électrode au potentiel de programmation subisse une programmation et que tout transistor qui a soit ses deux électrodes principales au même potentiel soit son électrode de commande au potentiel bas ne soit pas programmé.

3. Mémoire selon l'une des revendications 1 et 2, caractérisée en ce que le transistor est un transistor à grille flottante ayant une grille flotante, une grille de commande, une région de source et une région de drain, et une région de canal entre les régions de source et de drain, la grille flottante s'étendant sur une partie seulement de la région de canal et la grille de commande s'étendant sur le reste de la région de canal.

4. Procédé de fabrication d'une mémoire à grille flottante selon l'une des revendications 1 à 3, à partir d'un substrat de type p-, où on forme d'une part des lignes de bit diffusées de type n+ entre des colonnes de transistors, d'autre part des grilles flottantes à chaque position de transistor, et enfin des lignes de mot constituant en même temps des grilles de commande pour les transistors, caractérisé en ce que le procédé comprend en outre une étape d'oxydation effectuée dans des conditions telles que l'oxyde qui se forme soit nettement plus épais là où il recouvre des régions dopées de type n+ que là où il recouvre le substrat de type p-, et une étape d'implantation d'une impureté de type p masquée par l'oxyde plus épais et non masquée par l'oxyde moins épais.

## Patentansprüche

1. Speicher, umfassend ein Netzwerk von Wort-Leitungen (LM1, LM2,...), die Zellen in Reihen verbinden, und von Bit-Leitungen (LB1, LB2, ...), die Spalten-Zellen verbinden, wobei die Wort-Leitungen Leiter sind, die zur Angabe einer bestimmten Reihe von Zellen dienen, und die Bit-Leitungen Leiter sind, die die Übertragung einer Information über den logischen Zustand der Zellen gestatten, mit denen sie verbunden sind, wobei jede sich am Kreuzungspunkt einer bestimmten Reihe und einer bestimmten Spalte befindende Zelle einen Transistor (T11, T12, ...) umfaßt, der eine mit einer Wort-Leitung verbundene Steuerelektrode und zwei Hauptelektroden aufweist, von denen die eine mit einer ersten Bit-Leitung und die andere mit einer anderen, der ersten benachbarten Bit-Leitung verbunden ist, wobei diese andere Bit-Leitung selbst mit einer Hauptelektrode eines Transistors einer zur bestimmten Spalte benachbarten Spalte verbunden ist, zu der die Zelle gehört, jede Zelle besteht aus einem Transistor mit isoliertem Gate, wobei die Transistoren einer zu zwei Reihen und zwei benachbarten Spalten gehörenden Gruppe auf die folgende Weise eingerichtet sind:

– Jeder Transistor umfaßt ein isoliertes Gate, das im wesentlichen aus einem rechteckförmigen Leiter besteht, der sich oberhalb einer den Kanal des Transistors bildenden Zone von einem ersten Leitfähigkeitstyp befindet;
– die Kanäle von zwei benachbarten Transistoren einer selben Spalte sind durch einen Bereich vom selben Leitfähigkeitstyp wie die Kanäle getrennt;
– die Kanäle von zwei benachbarten Transistoren einer selben Reihe sind benachbart einem selben Bereich vom entgegengesetzten Leitfähigkeitstyp, der sie trennt und der als Source für den einen der Transistoren und als Drain für den anderen dient;
dadurch gekennzeichnet, daß
– es kein durch Oxidation des Siliciums gebildetes dickes Oxid, zum Trennen der Transistoren einer selben Spalte voneinander gibt.

2. Speicher nach Anspruch 1, dadurch gekennzeichnet, daß er Programmiermittel umfaßt, die zum Anlegen der folgenden Potentiale an die verschiedenen Zellen eingerichtet sind:

– an die Wort-Leitungen der Reihen von Zellen, die nicht programmiert werden sollen, wird ein niedriges Potential Vss angelegt;
– an die Wort-Leitung, die mit der zu programmierenden Leitung verbunden ist, wird ein Programmierpotential Vpp angelegt;
– an sämtliche Bit-Leitungen, die sich auf einer Seite der die zu programmierende Zelle enthaltenden Spalte befinden, wird ein Drain-Potential Vcc angelegt, und an sämtliche auf der anderen Seite der die zu programmierende Zelle enthaltenden Spalte wird ein Source-Potential angelegt;

das Source-Potential, das Drain-Potential und das Programmierpotential sind derart, daß der Transistor, dessen eine Hauptlektrode auf dem Source-Potential, die andere auf dem Drain-Potential und seine Elektrode auf dem Programmierpotential liegt, eine Programmierung erfährt und daß jeder Transistor, von dem entweder seine beiden Hauptelektroden auf dem selben Potential oder seine Steuerelektrode auf dem niedrigen Potential liegen, nicht programmiert wird.

3. Speicher nach einem der Ansprüche 1 und 2, dadurch gekennzeichnet, daß der Transistor ein Transistor mit isoliertem Gate ist, der ein isoliertes Gate, ein Steuergate, einen Sourcebereich und einen Drainbereich und einen Kanalbereich zwischen dem Source- und dem Drainbereich aufweist, wobei sich das isolierte Gate lediglich über einen Teil des Kanalbereichs erstreckt und das Steuergate sich über den Rest des Kanalbereichs erstreckt.

4. Verfahren zur Herstellung eines Speichers mit isoliertem Gate nach einem der Ansprüche 1 bis 3, ausgehend von einem Substrat vom p--Typ, bei dem zum einen zwischen den Spalten von Transistoren diffundierte Bit-Leitungen vom n+-Typ, zum anderen isolierte Gates an jeder Transistorposition und schließlich zugleich Steuergates für die Transistoren darstellende Wort-Leitungen gebildet werden, dadurch gekennzeichnet, daß das Verfahren außerdem einen Oxidationsschritt, der unter derartigen Bedingungen ausgeführt wird, daß das Oxid, das sich bildet, deutlich dicker dort ist, wo es mit n+-Typ dotierte Bereiche überdeckt, als dort, wo es das Substrat vom p--Typ überdeckt, und einen Schritt zur Implantation einer Verunreinigung vom p-Typ umfaßt, maskiert durch das dickere Oxid und nicht maskiert durch das dünnere Oxid.

**Claims**

1. A memory comprising a network of word lines (LM1, LM2, ...) connecting cells in rows and bit lines (LB1, LB2, ...) connecting cells in columns, the word lines being conductors acting to designate a specific row of cells and the bit lines being conductors making it possible to transmit data about the logic state of the cells which are connected to them, each cell, situated at the junction of a specific row and a specific column, comprising a transistor (T11, T12, ...) having a control electrode connected to a word line and two principal electrodes, one connected to a first bit line and the other connected to another bit line adjacent to the first, this other bit line being itself connected to a principal electrode of a transistor in a column adjacent to the specific column to which the cell belongs, and each cell being constituted by a floating gate transistor, the transistors of a group belonging to two a adjacent rows and two adjacent columns being formed in the following manner:

– each transistor comprises a floating gate substantially constituted by a rectangular conductor located above a region of a first type of conductivity constituting the channel of the transistor;
– the channels of two adjacent transistors in the same column are separated by a region of the same type of conductivity as that of the channels;

−the channels of two adjacent transistors in the same row are adjacent to a common region of the opposite type of conductivity which separates them and which acts as the source of one of the transistors and as the drain of the other, characterized in that

−there is no thick oxide layer formed by the oxidation of silicon for separating the transistors in a single column from one another.

2. A memory as claimed in claim 1, characterized in that it comprises programming means formed for applying the following potentials to the different cells:

−a low potential Vss is applied to the word lines of the rows of cells which do not have to be programmed;

−a programming potential Vpp is applied to the word line connected to the cell to be programmed;

−a drain potential Vcc is applied to all the bit lines located on one side of the column containing the cell to be programmed and a source potential is applied to all the bit lines located on the other side of the column containing the cell to be programmed;

the source potential, the drain potential and the programming potential being such that the transistor which has one principal electrode at the source potential, the other at the drain potential and its (control) electrode at the programming potential is programmed whereas any transistor which either has its two principal electrodes at the same potential or its control electrode at the low potential is not programmed.

3. A memory as claimed in either one of claims 1 and 2, characterized in that the transistor is a floating gate transistor comprising a floating gate, a control gate, a source region and a drain region and a channel region between the source and drain regions, the floating gate extending only over part of the channel region and the control gate extending over the remainder of the channel region.

4. A method for manufacturing a floating gate memory as claimed in any one of claims 1 to 3, from a p- type substrate where, on the one hand, diffused bit lines of type n+ are formed between columns of transistors and, on the other hand, floating gates are formed at each transistor site, and finally word lines are formed which at the same time constitute control gates for the transistors, characterized in that the method also comprises an oxidation step, performed under conditions such that the oxide which is formed is substantially thicker where it covers the n+ type doped regions than where it covers the p- type substrate, and a step of implantation of a p type impurity masked by the thicker oxide and not masked by the thinner oxide.

...

# FIG_1

# FIG_2

# FIG_3

COLONNE 1     COLONNE 2

B
T11     POLY 1
N⁺     P
T12

N⁺

LIGNE 1 { N⁺     Poly 2     LM1

A     P⁻     N     P⁻     A'

N⁺     P⁺     N⁺     P⁺     N⁺

LIGNE 2 { N⁺     P⁻     N⁺     P⁻     N⁺     Poly 2     LM2

N⁺     P⁺     T21 N⁺     P⁺     T22     LB2

LB0     B'     LB1

# FIG_4

T11     T12     LM1 (POLY2)

POLY1     POLY1

N⁺     N⁺

LB0     P⁻     LB1     LB2

COUPE AA'

LM1     LM2

POLY2     POLY2

POLY1     POLY1

P⁻     P⁺     P     P⁺

T11     T21

# FIG_5

COUPE BB'

# FIG_6

T11     T12     LM1 (POLY2)

POLY 1     POLY 1

N⁺     N⁺     N⁺

LB0     LB1     P⁻     LB2

# FIG_7

PLAN MEMOIRE

PERIPHERIE

$n$

RESINE

$SiO_2$

$p^-$

$p^-$

# FIG_8

$SiO_2$

$SiO_2$

$p^-$

$n$

$p^-$

# FIG_9

POLY 1

$n$

$p^-$

# FIG_10

RESINE

n+    n+    n+

LB0    P-    LB1    P-    LB2    n    P-

# FIG_11

POLY 2

n+    n+    POLY1    n+    SiO2    n

LB0    LB1    SiO2    LB2

# FIG_12

POLY2    LM1    POLY 2

n+    POLY1    n+    SiO2

LB0    LB1    LB2

# FIG_13

LM1    LM2 (POLY 2)    POLY2

SiO2    SiO2

POLY1

P-